# EUROPÄISCHE PATENTSCHRIFT

(11) **EP 0 801 147 B1**
(45) Veröffentlichungstag und Bekanntmachung des Hinweises auf die Patenterteilung: **16.01.2002**
(21) Anmeldenummer: 97101690.2
(22) Anmeldetag: 04.02.1997
(51) Int. Cl.: C23C 14/50, C23C 14/56

(54) **Vorrichtung zum Transport von Substraten**
Apparatus for transporting substrates
Dispositif de transport de substrats

(30) Priorität: 13.04.1996 DE 19614596
(43) Veröffentlichungstag der Anmeldung: 15.10.1997
(73) Patentinhaber: Singulus Technologies AG, 63755 Alzenau (DE)
(72) Erfinder: Kempf, Stefan, 63755 Alzenau-Albstadt (DE)
(74) Vertreter: VOSSIUS & PARTNER

(56) Entgegenhaltungen:
- EP-A- 0 389 820
- EP-A- 0 589 416
- EP-A- 0 790 330
- WO-A-86/06753
- DE-U- 9 307 263

## Beschreibung

Die Erfindung bezieht sich auf eine Vorrichtung zum Transport von Substraten zwischen einer ersten und mindestens einer zweiten Vorrichtung zum Greifen und Halten von Substraten mit einem oder mehreren in einer Vakuumkammer angeordneten Substrathaltern.

Die DE-U-93 07 263 betrifft eine Vorrichtung zum Greifen und Halten eines scheibenförmigen Substrats mit mehreren Greifern und einer Membran aus elastischem Material, die eine, in einem druckfesten Gehäuse angeordnete Öffnung verschließt. Auf der Vorder- und Rückseite der Membran sind unterschiedliche Drücke einstellbar und die Membran ist so angeordnet, daß sie bei anliegender Druckdifferenz eine Auslenkung aus ihrer Ruhelage ausführt und bei Druckgleichheit durch eine Druckfeder wieder in ihre Ruhelage zurückstellbar ist. Die Greifer sind mit ihrem jeweils einen Ende mechanisch mit der Membran so verbunden, daß sie mit ihrem anderen, freien Ende eine Schwenkbewegung proportional zur Auslenkung der Membran zum Greifen und Halten bzw. zum Freigeben des Substrats ausführen.

Die EP-A-389 820 betrifft eine Vorrichtung zum Einund Ausschleusen eines Werkstücks in eine Vakuumkammer, in dem sich ein Transportmittel für die Beförderung des Werkstücks befindet. Das scheibenförmige Transportmittel ist mit mindestens einer durchgehenden Öffnung versehen, deren Rand ein plattenförmiges Hub- und Stützelement für eine Haltevorrichtung für das Werkstück zeitweise umgibt.

Die EP-A-589 416 betrifft eine Beschichtungsvorrichtung mit einer Beschichtungskammer, in der auf einem Substrat in einer bestimmten Position ein Film ausgebildet wird. Die Vorrichtung weist ferner mehrere durch Ventile gebildete Beladeblockierkammern, mehrere in der Beschichtungskammer vorgesehene Dreheinrichtungen und Transportarme auf, die von den Dreheinrichtungen getragen werden, um die Substrate von jeder der Beladeblockierkammern zu den Beschichtungspositionen und umgekehrt zu transportieren.

Die EP-A-790 330 beschreibt eine Vorrichtung zum Transport von Substraten zwischen einer ersten und mindestens einer zweiten Vorrichtung zum Greifen und Halten von Substraten mit einem oder mehreren in einer Vakuumkammer angeordneten Substrathaltern. Die erste Vorrichtung zum Greifen und Halten von Substraten ist mit einem oder mehreren verstellbar angeordneten Greifern ausgerüstet, die mittels einer mechanischen und/oder elektromechanischen bzw. magnetisch arbeitenden Stelleinrichtung in eine das Substrat haltende bzw. freigebende Stellung verstellbar sind. Die zweite Vorrichtung zum Greifen und Halten der Substrate ist koaxial zur ersten Vorrichtung ausgerichtet und weist ebenfalls einen oder mehrere verstellbar angeordnete Greifer auf. Diese Druckschrift repräsentiert Stand der Technik gemäß Art. 54(3) EPÜ und wurde am 20. August 1997 veröffentlicht. Der Gegenstand dieser Veröffentlichung geht auf den Erfinder der vorliegenden Erfindung zurück und wurde am 04. Februar 1997 unter Inanspruchnahme einer Priorität vom 15. Februar 1996 angemeldet.

Der vorliegenden Erfindung liegt die Aufgabe zugrunde, eine verbesserte Vorrichtung zum Transport von Substraten zur Verfügung zu stellen. Die Aufgabe wird mit den Merkmalen von Anspruch 1 gelöst. Bevorzugte Ansführungsformen der Erfindung sind in den abhängigen Patentansprüchen enthalten.

Die Erfindung geht dabei von dem Grundgedanken aus, daß der Stelleinrichtung und/oder einem das Substrat aufnehmendem Teil eine Zentriereinrichtung zugeordnet ist. Auf diese Weise wird die Übergabe des Substrats von den Substratgreifern an ein Aufnahmeteil bzw. einen Substratteller wesentlich verbessert, da mittels der Zentriereinrichtung eine exakte koaxiale Ausrichtung des Substrats gegenüber dem Substratteller gewährleistet wird, was insbesondere dann wichtig ist, wenn dieser um seine Achse gedreht werden soll.

Im Rahmen der Erfindung wird vorzugsweise sichergestellt, daß der Greifkopf stets in seine oberste bzw. Ausgangsstellung zurückverstellt wird sobald das Substrat auf seine Ablagefläche gelegt ist, um dieses automatisch zu zentrieren.

Ferner wird entsprechend eines bevoreugten Ausführungform vermieden, daß die Substratgreifer mit der Zentriervorrichtung kollidieren, wenn ein Substrataustausch erfolgen soll.

Durch einen konischen Teil an der Zentriervorrichtung kann das Substrat mittels seines Eigengewichts auf der Zentriervorrichtung nach unten in Richtung des Substrattellers verschoben werden.

Vorteilhaft ist es ferner, daß die erste Vorrichtung zum Greifen und Halten von Substraten mit einem oder mehreren verstellbar angeordneten Greifern ausgerüstet ist, die mittels einer mechanischen und/oder elektromechanischen bzw. magnetisch arbeitenden Stelleinrichtung in eine das Substrat haltende bzw. freigebende Stellung verstellbar sind, wobei die zweite Vorrichtung zum Greifen und Halten von Substraten mit einem oder mehreren verstellbar angeordneten Greifern ausgerüstet ist, die gegen die Wirkung eines Stelldrucks bzw. gegen die Wirkung einer Feder in eine erste Stellung und über die Wirkung einer einem pneumatischen Druck Pₐ und/oder Vakuumdruck Pᵥ aussetzbaren Membrane und eines mit dieser zusammenwirkenden Stellteils in eine zweite Stellung verstellbar sind, wobei in der einen Stellung das Substrat gehalten und in der zweiten Stellung das Substrat für den Weitertransport gelöst wird, wobei in der Stellung der beiden Vorrichtungen zur Übergabe des Substrats die beiden Substrataufnahmeteile koaxial zueinander ausrichtbar und fixierbar sind.

Durch die vorteilhafte Zusammenführung der elektromechanischen Vorrichtung zum Greifen von Substraten mit der über Vakuumdruck steuerbaren Vorrichtung zum Greifen der Substrate wird ein störungsfreier Prozeßablauf zwischen den beiden Greifvorrichtungen gewährleistet und gleichzeitig auch sichergestellt, daß keine Beschädigung an der Oberfläche der Substrate erfolgt, da diese in die in den Substraten vorgesehenen Öffnungen eingreifen und auf diese Weise die Substrate in der gewünschten Position halten. Durch die elektromechanische Verstellvorrichtung und die zugehörigen Greifer, die mittels der Verstellvorrichtung eine Kippbewegung ausführen, kann das Substrat ohne weiteres in der hierfür vorgesehenen Öffnung erfaßt und gesichert werden, wozu die entsprechenden Greifer in eine vertikale Lage verstellt werden. Durch die Magneten erhält man eine optimale Stellkraft, die in Millisekunden die gewünschte Schwenkbewegung an den Greifern herbeiführt. Nach der Übergabe von einer Greifvorrichtung zu einer anderen wird über die Vakuumsteuerung der zweite Greifer zur Aufnahme des Substrats angesteuert, wobei hier in optimaler Weise der Vakuumdruck der zweiten Vakuumkammer eingesetzt und somit auf sämtliche Zusatzaggregate verzichtet werden kann. Auch diese zweite Greifvorrichtung arbeitet sehr exakt, und durch das Eingreifen dieser Greifer in die im Substrat vorgesehene Bohrung wird ebenfalls sichergestellt, daß die Oberfläche der Substrate in keiner Weise kontaktiert wird.

Durch den exakt steuerbaren Prozeßablauf und die genaue Abstimmung der beiden zusammenwirkenden Greifvorrichtungen läßt sich eine exakte Weitergabe des Substrats von der einen zu der anderen Vorrichtung durchführen, wobei hierzu mit einem Minimum an Bauteilen ausgekommen werden kann.

Durch Verwendung von länglichen, relativ schmal ausgebildeten Greifern zur Aufnahme der Substrate lassen sich entsprechende Zwischenräume zwischen den einzelnen Substrathaltern schaffen, so daß zwei zusammenwirkende Vorrichtungen sehr dicht aneinander herangefahren werden können, um eine exakte Übergabe der Substrate zwischen den beiden Vorrichtungen zu gewährleisten.

Durch die vorteilhafte Anordnung einer Membrane, die in die Vakuumkammer hineinragt, kann erstmalig auf einfache Weise der in der Kammer auftretende Vakuumdruck als Stellgröße zum Verstellen der Membrane eingesetzt werden.

Durch Verwendung eines flexiblen und eines nicht flexiblen Teils zur Bildung der Membrane wird eine exakte Führung des Stellteils zum Verstellen bzw. Verschwenkung der Greifer geschaffen.

Durch die Verwendung einer Nut zur Aufnahme eines äußeren Randes der Membrane erhält man eine sehr einfache Befestigungsart für die Membrane, die außerdem eine hohe Dichtigkeit gegenüber der gefluteten Kammer und der Vakuumkammer aufweist. Da der Teller über einen koaxialen Zapfen mit dem zylinderförmigen Teil verbunden bzw. verschraubt ist, kann bei Beschädigung der Membrane diese ohne weiteres gelöst werden. Hierzu braucht lediglich der Teller abgeschraubt und die Klemmverbindung der Membrane gelöst zu werden. Danach lassen sich diese Teile ohne weiteres ersetzen.

Durch die Verwendung einer zylinderförmigen Verlängerung auf dem feststehenden Flansch wird eine gute Führung der Feder gewährleistet und gleichzeitig sichergestellt, daß bei Druckausgleich zwischen den beiden Kammern ein sofortiges Verstellen der Greifer erfolgt.

Da das Tragteil zur Aufnahme der Greifer vorzugsweise zwischen den beiden Flanschen angeordnet ist, erhält man eine sehr gute, einfache Fixierung der Halterung.

Weitere Vorteile und Einzelheiten der Erfindung sind in den Patentansprüchen und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Figur 1: eine schematische Darstellung des Funktionsablaufs der Gesamtvorrichtung einer Sputteranlage,
- Figur 2: eine perspektivische Darstellung einer Vorrichtung zum Beschichten von Compact Disks,
- Figur 3: eine Vorrichtung zum Greifen und Halten eines flachen, vorzugsweise scheibenförmigen Substrats,
- Figur 4: eine Schnittdarstellung eines ersten Substratgreifers mit einer elektromagnetisch wirkenden Stellvorrichtung,
- Figur 5: eine schematische Darstellung der Greifer von beiden Vorrichtungen in einer Ansicht von unten,
- Figur 6: die Gesamtvorrichtung zur Übergabe der Substrate von einer Vorrichtung mit der elektromagnetischen Stellvorrichtung an die zweite Vorrichtung mit über Vakuum steuerbaren Greifern,
- Figur 7: eine membranartige Feder zwischen einem Drehteller und einem Substrathalter gemäß Figur 6.
- Figur 8: eine Schnittdarstellung weiteren Ausführungsbeispieles eines ersten Substratgreifers mit einer elektromagnetisch wirkenden Stellvorrichtung sowie eine Stellvorrichtung zur Verstellung eines Zentrierstiftes für das Substrat,

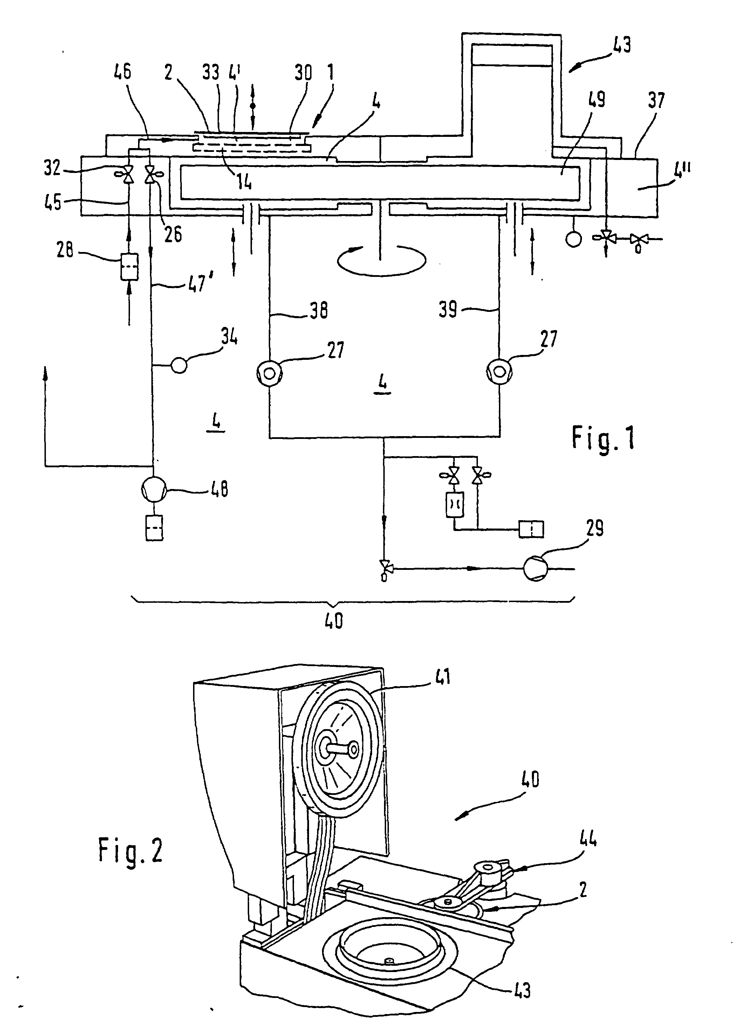

In der Zeichnung ist in Figur 2 eine perspektivische Darstellung eines oberen Teils einer Sputteranlage 40 wiedergegeben, zu dem ein um 180° drehbar gelagerter Greiferarm 44 gehört, mittels dessen die in Figur 2 mit 2 bezeichneten Substrate bzw. Compact Disks (CD) einer Vorrichtung 1 zum Greifen von Substraten (Disk-Receiver) zugeführt werden. Über diese Vorrichtung gelangen die Substrate zu einer Prozeßstation 43, zu der auch eine in Figur 2 in einer geöffneten Stellung wiedergegebene Kathode 41 gehört.

In Figur 1 ist das Funktionsschema der Sputteranlage 40 mit den wesentlichen Vorrichtungsteilen wiedergegeben.

Das Substrat 2 wird mittels des Greiferarms 44 und eines zugehörigen Tellers 33, zu dem ebenfalls eine in Figur 1 nicht dargestellte Greifvorrichtung gehört, einer weiteren Vorrichtung zum Greifen von Substraten aufgegeben. In Figur 1 befindet sich der Teller 33 oberhalb eines Tellers bzw. Substrataufnahmeteils 14. In der Stellung gemäß Figur 1 sind die beiden Teller 33 und 14 koaxial zueinander ausgerichtet, so daß das Substrat 2 von dem Teller 33 dem Substrataufnahmeteil 14 aufgegeben werden kann.

In der Stellung gemäß Figur 1 ist der Teller 14 nach oben gefahren und dichtet ein ringförmiges Volumen bzw. eine Einschleuskammer 30 ab. Die Einschleuskammer 30 befindet sich zwischen dem oberen Teller 33 und dem unteren Teller bzw. Substrataufnahmeteil 14. Die am Teller 33 vorgesehenen, in Fig. 1 nicht dargestellten Greifelemente halten die Compact Disk oberhalb des Substrataufnahmeteils 14.

Die Einschleuskammer 30 kann über einen Filter 28 geflutet werden, der hierzu über eine Leitung 45 mit einem Ventil 32 verbunden ist, das über eine weitere Leitung 46 an die Einschleuskammer 30 angeschlossen ist. Durch Öffnen des Ventils 32 wird die Einschleuskammer 30 geflutet. Nachdem die Einschleuskammer 30 geflutet ist, wird der obere Teller angehoben, so daß das Substrat 2 ausgetauscht werden kann. Mittels des Greiferarms 44 kann die fertig beschichtete Compact Disk einer weiteren nicht dargestellten Transporteinrichtung zugeführt werden. Gleichzeitig wird eine neue zu bearbeitende Compact Disk 2 in die Einschleuskammer 30 eingelegt. Durch Absenken des Deckels 33' preßt sich ein in der Zeichnung nicht dargestellter O-Ring gegen die Oberfläche eines Gehäuses 37 der Einschleuskammer 30 an, die dadurch vakuumdicht verschlossen wird. Der in der Einschleuskammer 30 herrschende Atmosphärendruck wird durch Schließen des Ventils 32 und dann durch anschließendes Öffnen eines Ventils 26, das über die Leitung 46 mit der Einschleuskammer 30 verbunden ist, evakuiert. Eine Vakuumpumpe 48 pumpt über die Leitung 47' die in der Einschleuskammer 30 vorhandene Luft ab und erzeugt den erforderlichen Vakuumdruck.

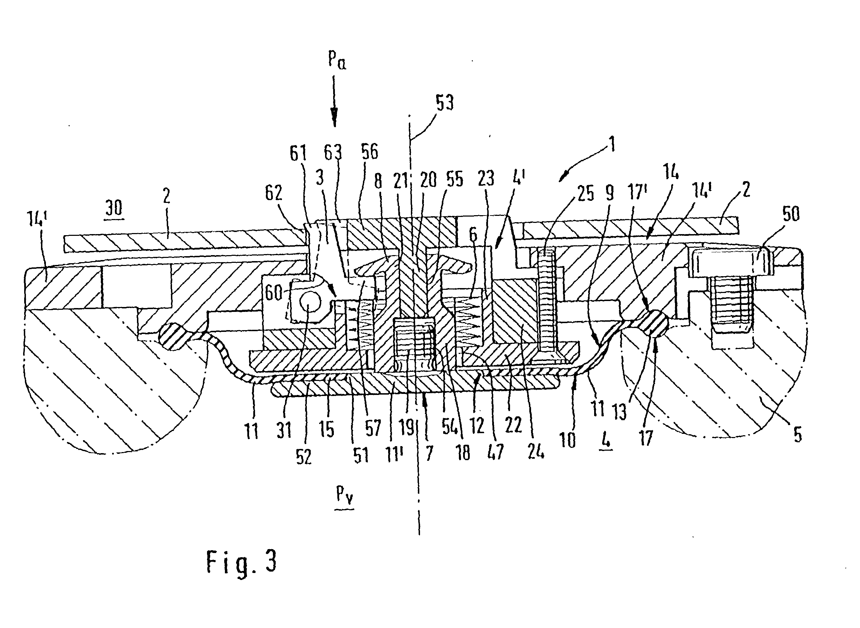

Bei diesem Vorgang öffnen sich nachstehend näher erläuterte Greifer 3, die in Figur 3 im Detail wiedergegeben sind. Die Greifer 3 erfassen das Substrat 2 bzw. die Compact Disk. Dies tritt sofort ein, wenn der Druck in der Einschleuskammer 30 in etwa dem Druck in einer Vakuumkammer 4 (Figur 3) entspricht, d. h. wenn Druckausgleich erfolgt ist. Ist die Einschleuskammer 30 soweit evakuiert, daß der erforderliche Meßdruck, der mittels einer Meßzelle 34 ermittelt wird, hergestellt ist, so kann die Vorrichtung 1 nach unten abgesenkt und das auf einem Drehteller 49 (Figur 1) abgelegte Substrat 2 mittels des Drehtellers 49 der Prozeßstation 43 schrittweise zugeführt werden. Hierzu dreht sich der Drehteller 49 jeweils um 120° weiter.

Anschließend wird das Substrataufnahmeteil 14 angehoben, wobei sich ein nicht dargestellter O-Ring gegen die Unterseite des Deckels der Kathode 41 legt.

Nach diesem Arbeitsschritt kann die Einschleuskammer 30 wieder über das Ventil 32 geflutet werden. Bei diesem Flutungsvorgang entsteht eine Druckdifferenz P_{d}, die sich aus dem Atmosphärendruck Pₐ in der Einschleuskammer 30 und dem Vakuumdruck Pᵥ in der Vakuumkammer 4 (siehe Figur 3) ergibt (P_{d} = Pₐ - Pᵥ).

Durch diese Druckdifferenz werden die Greifer 3 wieder verschwenkt und das Substrat 2 freigegeben. Bei diesem Arbeitsvorgang wird gleichzeitig auch der Greifer des Substrataufnahmeteils bzw. des Tellers 33 aktiviert, so daß das Substrat von dem Teller 33 übernommen werden kann. Dieser Arbeitsprozeß wiederholt sich fortlaufend.

Die Vakuumkammer 4 wird über die Leitungen 38, 39 und die Vorpumpe 29 evakuiert.

In Figur 3 ist die Vorrichtung 1 zum Greifen und Halten der Substrate 2 im Detail wiedergegeben, wobei die Vorrichtung 1 lediglich schematisch angedeutet ist.

Die Vorrichtung 1 besteht aus einem Flansch 14', der über Schraubenbolzen 50 mit einem Substrathalter 5 lösbar verbunden ist. Zwischen dem Flansch 14' und dem Substrathalter 5 ist eine halbkreisförmige Nut 17 vorgesehen, in der ein wulstartiger Rand 13 einer Membrane 7 eingeklemmt ist. Die Membrane 7 befindet sich in der Vakuumkammer 4 und besteht aus einem flexiblen Teil 11 und einem an diesen angeschlossenen, nicht flexiblen Teil 11', der als kreisrunder Teller ausgebildet ist und der in einer Öffnung 12 der Membrane 7 eingelassen ist. Hierzu weist der Teller 11' einen zylinderförmigen Ansatz 51 auf, so daß ein Randteil 52 gebildet wird, an das der flexible Teil 11 der Membrane 7 befestigt bzw. anvulkanisiert sein kann. Die Membrane 7 dichtet den oberen Teil einer Vakuumkammer 4' (Figur 3) bzw. 4'' (Figur 1) gegenüber der einem permanenten Vakuumdruck Pᵥ ausgesetzten Vakuumkammer 4 ab. Der flexible Teil 11 der Membrane 7 ist mit seinem äußeren Rand 13 an einen Flansch 14' und mit seinem innenliegenden Rand 15 an den zylinderförmigen Ansatz 51 angeschlossen. Der äußere Rand 13 ist in einer Nut 17, 17' des Flansches 14' und dem Substrathalter 5 eingeklemmt.

Die Vakuumkammer 4', 4'' wird dann einem Atmosphärendruck Pₐ ausgesetzt, wenn, wie bereits erwähnt, das Ventil 32 geöffnet und die Einschleuskammer 30 geflutet wird.

Der Teller 11' der Membrane 7 weist einen Zapfen 19 auf, der koaxial zu einer Mittelachse 53 der Vorrichtung 1 ausgerichtet ist. Der Zapfen 19 ist fest bzw. einteilig mit dem Teller 11' verbunden. Der Zapfen 19 weist Außengewinde 54 auf und kann daher mit einem zylinderförmigen Teil 18 verbunden bzw. lösbar verschraubt werden.

Das zylinderförmige Teil 18 ist hierzu ebenfalls koaxial zum Flansch 14' ausgerichtet und weist in seinem oberen Bereich eine zylinderförmige Bohrung 55 auf, in die sich ein Zapfen 20 erstreckt. Der Zapfen 20 ist mit einem zylinderförmigen Ansatz 56 verbunden, der über Verbindungselemente 25 mit dem Flansch 14' verbunden ist. Auf den zylinderförmigen Ansatz 56 kann die Compact Disk bzw. das Substrat 2 aufgeschoben und mittels der drei oder mehreren Greifer 3 gehalten werden. Der zylinderförmige Teil 18 ist bei auftretender Druckdifferenz P_{d} mit Bezug auf die Mittelachse 53 auf dem Zapfen 20 vertikal verstellbar.

Am oberen Ende des zylinderförmigen Teils 18 ist ein Stellteil bzw. ein glockenförmig ausgebildeter Flansch 8 vorgesehen. Das Stellteil 8 ist an einem oberen Ende 21 des zylinderförmigen Teils 18 fest angeschlossen.

Wie aus Figur 3 3 hervorgeht, liegt der Flansch 8 8 mit seinem äußeren Ende gegen einen Hebelarm 57 je eines Greifers 3 an. Der Greifer 3 ist auf einem mit Bezug auf Figur 3 horizontal verlaufenden Bolzen 31 zwischen der in ausgezogenen Linien dargestellten Stellung (Haltestellung) und einer in gestrichelten Linien dargestellten Stellung (Freigabestellung) verschwenkbar gelagert.

Das untere Ende des zylinderförmigen Teils 18 bewegt sich mit seinem einen Ende bzw. seinem Teller 11' in Richtung der Unterseite eines feststehenden Flansches 22, während er mit seinem anderen Ende bzw. seinem Stellteil 8 gegen den Greifer 3 bzw. dessen Hebelarm 57 anliegt. In diesem Betriebszustand befindet sich der Greifer 3 in der in Figur 3 dargestellten Halteposition, in der das Substrat 2 von den Greifern 3 getragen wird. Der Flansch 22 ist über die Verbindungselemente 25 mit einem Tragteil 24 und dem Flansch 14' fest verbunden. Auf dem Flansch 22 befindet sich eine zylinderförmige Verlängerung 23, in der eine Feder bzw. Tellerfeder 6 aufgenommen ist. Die Feder 6 stützt sich mit ihrem unteren Ende gegen den Flansch 22 und mit ihrem oberen Ende gegen den Hebelarm 57 des Greifers 3 ab und drückt diesen bei Druckausgleich Pₐ = Pᵥ in seine Halteposition gemäß Figur 3. Hierzu umgibt die zylinderförmige Feder 6 6 das zylinderförmige Teil 18. Das mit dem Flansch 22 verbundene Tragteil 24 dient zur verschwenkbaren Aufnahme der Greifer 3. Der Flansch 22 weist eine Bohrung 47 auf, durch die sich das zylinderförmige Teil 18 erstreckt.

Der feststehende Flansch 22 und der Tragteil 24 sind über die gleichen Verbindungselemente 25 mit dem Flansch 14' der Vorrichtung 1 lösbar verbunden. Die oberhalb der Membrane 7 vorgesehene Vakuumkammer 4', 4'' bzw. die Einschleuskammer 30 kann, wie bereits mit Bezug auf Figur 1 erläutert, über das Ventil 32 geflutet und über die Pumpe 48 evakuiert werden. Die unterhalb der Membrane 7 vorgesehene Vakuumkammer 4 wird bei Arbeitseinsatz nicht geflutet und über eine Vakuumpumpe 27 (z.B. Turbo-Molekularpumpe) bzw. die Vorpumpe evakuiert bzw. auf einem bestimmten Druckniveau gehalten.

Wird für den Arbeitsprozeß und zum Transport des Substrats 2 die Einschleuskammer 30 bzw. Vakuumkammer 4' über das Ventil 32 gemäß Figur 1 geflutet, so tritt oberhalb der Membrane 7 ein sofortiger Druckanstieg Pₐ ein, so daß die Membrane 7 aufgrund der Druckdifferenz (P_{d} = Pₐ - Pᵥ) weiter in die Vakuumkammer 4 gemäß Figur 3 nach unten bewegt wird und mittels des Stellteils 8 der Greifer 3 aus der in ausgezogenen Linien dargestellten Stellung in die in gestrichelten Linien dargestellte Stellung (Freigabestellung für Substrat) im Uhrzeigerdrehsinn gemäß Pfeil 60 um einem Bolzen 31 verschwenkt wird. Dabei gelangt der obere Teil 61 des Greifers 3 aus dem Bereich eines Randes 62 einer Bohrung 63 des Substrats 2 und gibt auf diese Weise das Substrat bzw. die Compact Disk zum Transport frei.

Mit der erfindungsgemäßen Anlage wird also immer dann ein zwangsweises Verstellen des Greifers 3 in eine Freigabestellung gemäß Figur 3 bewirkt, wenn die Einschleuskammer 30 geflutet wird.

Wird nach der Substratübergabe die Einschleuskammer 30 bzw. Vakuumkammer 4' über die Pumpe 48 wieder evakuiert, so erfolgt zwischen der Einschleuskammer 30 und der Vakuumkammer 4 ein Druckausgleich, so daß dadurch die Feder (z.B. Tellerfeder) 6 den Hebelarm 57 und dadurch auch das Stellteil 8 nach oben bewegt, da nun auf einer Seite 9 und einer anderen Seite 10 der Membrane 7 die gleichen Druckzustände herrschen. Hierdurch arbeitet das Greifersystem völlig störungsfrei und kann in kürzester Zeit, also in Millisekunden, ansprechen.

Durch die sehr kurze Ansprechzeit der Greifer 3 und das zwangsweise Verstellen beim Fluten der Einschleuskammer 30 wird die Standsicherheit bzw. der Arbeitsprozeß störungsfreier und die Taktzeit zusätzlich verringert. Außerdem kann durch diese Anordnung die Vorrichtung 1 zum Greifen der Substrate wesentlich einfacher gestaltet und somit kostengünstiger hergestellt werden, da man insgesamt mit weniger Bauteilen auskommen kann. Die bisherige externe Ansteuerung der Membrane zum Verstellen der Greifer 3 war aufgrund der fehlenden Einzelteile störanfälliger und nicht so funktionssicher, wenn z. B. die externe Versorgungspumpe zur Erzeugung eines Überdrucks an der Membrane 7 ausfiel.

Die Oberseite der Membrane ist über die Bohrung 47 mit der Vakuumkammer 4' verbunden.

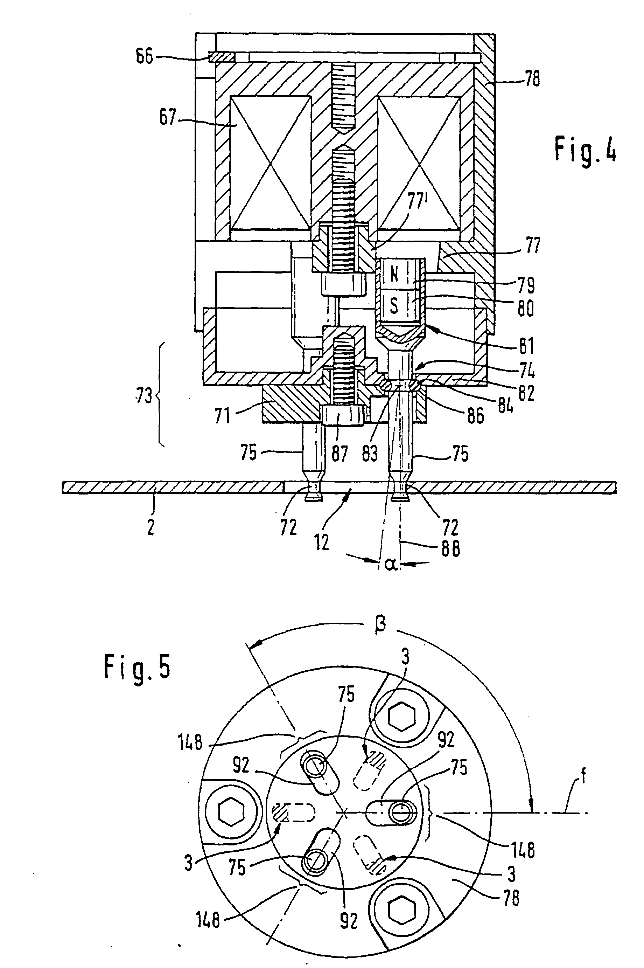

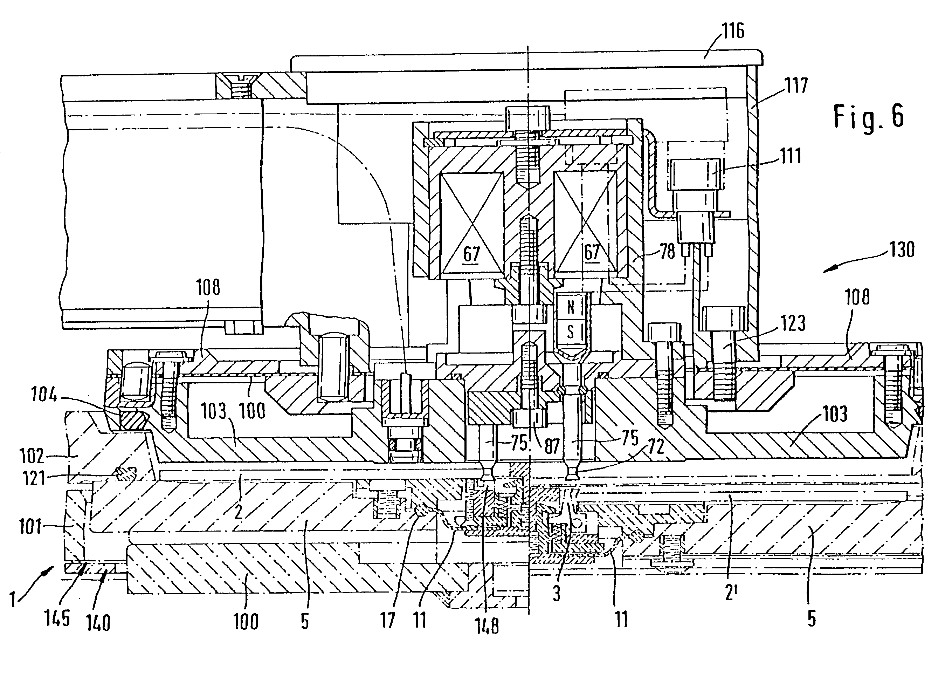

In Figur 4, 6 ist eine erste Vorrichtung 130 zum Greifen und Halten der Substrate 2 gezeigt, zu der die um eine mit Bezug auf Figur 4 horizontal verlaufende Achse 83 schwenkbaren Greifer 75 gehören. Die Greifer 75 sind hierzu in einem zylinderförmigen Gehäuse 78 angeordnet, das zur Aufnahme eines Elektromagneten (z.B. Ringmagnet) 67 dient, der über einen Stecker 111 mit einer in der Zeichnung nicht dargestellten Stromversorgungseinrichtung verbindbar ist (vgl. Figur 6). Der Elektromagnet 67 ist mittels eines Sicherungsrings 66 gesichert, der am oberen Ende des Gehäuse 78 vorgesehen ist. Am unteren Ende weist das Gehäuse einen Boden 82 mit mindestens drei Öffnungen 74 auf, durch die sich die Greifer 75 erstrecken. Die Greifer 75 sind über elastisch ausgebildete Lager 84 um die mit Bezug auf Figur 4 horizontal verlaufende Achse 83 zwischen zwei Anschlägen 77, 77', die fest mit dem Gehäuse 78 verbunden sind, verschwenkbar.

Wie aus Figur 4 hervorgeht, weist das obere Ende eines jeden Greifers 75 ein zylinderförmiges Gehäuse 81 zur Aufnahme eines oberen und eines unteren Magneten 79 und 80 auf. Die Wand des zylinderförmigen Gehäuses 81 ist dünnwandig ausgebildet und kann eine Wandstärke zwischen 0,2 mm und 1,0 mm bzw. zwischen 0,3 mm und 0,7 mm bzw. zwischen 0,4 mm und 0,6 mm, insbesondere 0,5 mm, aufweisen, um am Magneten 67 bei Anlage eine gute Haltekraft zu gewährleisten.

Im Ausführungsbeispiel ist der obere Magnet mit N und der untere Magnet mit S bezeichnet. Durch Einschalten des Ringmagneten 67 läßt sich der Greifer 75 zwischen den beiden Anschlägen 77 und 77' verstellen und legt dabei den Weg, der durch den Winkel α gekennzeichnet ist, zurück. In der Halteposition verläuft die Längsmittelachse 88 des Greifers 75 parallel zur Längsmittelachse des Gehäuses 78. In dieser Stellung wird das Substrat über am unteren Ende des Greifers vorgesehene nutenförmige Vertiefungen 72 gesichert.

wie aus Figur 5 hervorgeht, erstrecken sich die unteren Enden der Greifer durch Langlochöffnungen 92, die eine exakte Führung der Greifer gewährleisten. Wird mit Bezug auf Figur 4 durch entsprechende Polungen des Ringmagneten 67 der Greifer 75 verschwenkt, so bewegt er sich von dem linken Anschlag 77' zu dem rechten Anschlag 77 und nimmt dabei eine geneigt verlaufende Haltung ein, so daß er sich mit seiner Vertiefung 72 aus dem Randbereich der Bohrung bzw. Öffnung 12 des Substrats 2 wegbewegt und dieses für die Übergabe der zweiten Vorrichtung 1 freigibt.

Nach dem Ausführungsbeispiel gemäß Figur 4 4 kann das elastisch ausgebildete Lager 84 in einer entsprechenden im Boden 82 und einem sich daran anschließenden Aufnahmeteil 71 vorgesehenen Ringnut 86 aufgenommen sein. Das Aufnahmeteil 71 ist hierzu über Schrauben 87 mit dem Boden 82 des Gehäuses 78 lösbar verbunden.

Wie aus Figur 5 hervorgeht, sind die einzelnen Greifer 75 der ersten Vorrichtung 130 jeweils um 120° versetzt zueinander ausgerichtet und bilden auf diese Weise Zwischenräume 148, die ausreichend Platz für die Greifer 3 der zweiten Vorrichtung 1 zum Greifen von Substraten bieten. Durch die vorteilhaft angeordneten Zwischenräume 148 können die beiden Vorrichtungen 1 und 130 sehr dicht aneinander herangeführt werden und somit eine exakte Übergabe der Substrate zwischen den beiden Vorrichtungen sichergestellt werden, wobei bei der Übergabe die oberen Greifer 75 kurzfristig in die Zwischenräume 148 der jeweils zwei nebeneinander liegenden, unteren Greifer 3 eingreifen, wenn die beiden Vorrichtungen zusammengefahren werden.

Wie aus Figur 5 ferner hervorgeht, beträgt der Winkel β zwischen zwei nebeneinander liegenden Greifern 75 120°. Die Greifer 75 sowie die Greifer 3 sind jeweils sternförmig angeordnet, und der Winkel zwischen dem Greifer 75 und dem Greifer 3 beträgt 60°.

Die in Figur 4 wiedergegebene Vorrichtung zum Greifen und Halten der Substrate 2 ist in Figur 6 in der Gesamtvorrichtung veranschaulicht, wobei die Vorrichtung 130 als obere Vorrichtung dargestellt ist. Ein aus den Greifern 75 gebildetes Substrataufnahmeteil 73 mit den Elektromagneten 67 ist, wie aus Figur 6 hervorgeht, in einem einen Deckel 116 aufweisenden Greiferträger 117 aufgenommen, der über Schraubenbolzen 123 mit einem Anschlagdeckel 108 lösbar verbunden ist. An den Anschlagdeckel 108 ist mittels der Schraubenbolzen 123 ein Schleusendeckel 103 lösbar angeschlossen. Das Substrataufnahmeteil 73 mit dem Schleusendeckel 103 bildet die obere Vorrichtung 130 zum Aufnehmen und Greifen der Substrate 2. Wird das Substrat 2 über die gesamte Vorrichtung 130 an die in Figur 3 3 bereits ausführlich beschriebene zweite Vorrichtung 1 herangefahren, so legt sich der Schleusendeckel 103 mittels einer Dichtung 104 dichtend gegen die Stirnfläche eines Rezipientendeckels 102, 41 an. Dabei bildet sich zwischen der Oberfläche des Substrathalters 5 und der Unterseite des Schleusendeckels 103 die Einschleuskammer 30, die über die Leitung 46 entweder geflutet oder evakuiert werden kann, wie das aus der schematischen Darstellung gemäß Figur 1 hervorgeht.

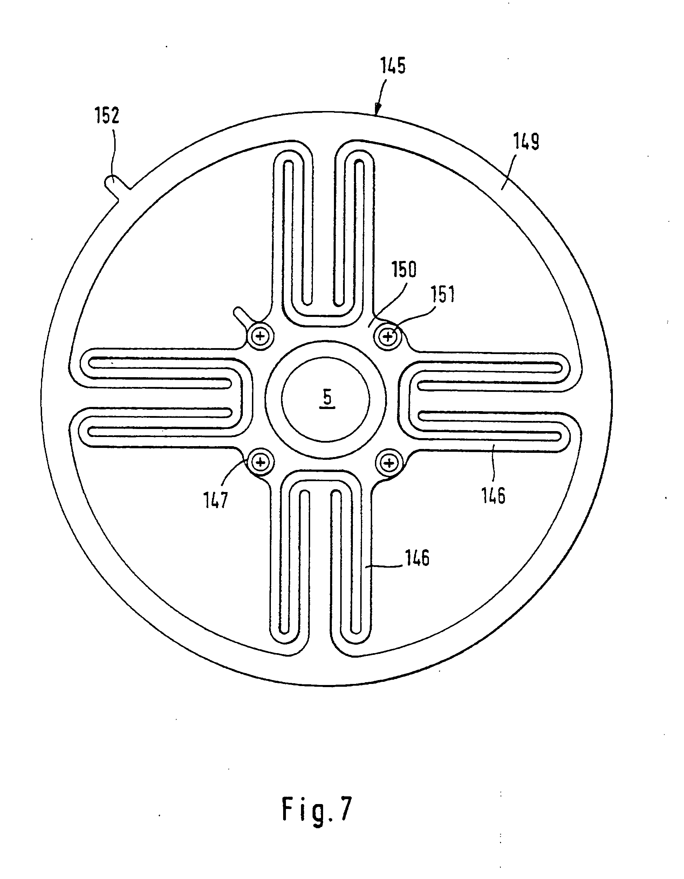

In Figur 7 ist zwischen einem Drehteller 101 gemäß Figur 6, der zweiten Vorrichtung 1 und dem Substrathalter 5 ein einen Hub zulassendes, federelastisches Verbindungselement 147 bzw. Membranteil 145 vorgesehen, das als kreisförmige Scheibe mit einem äußeren Rand 149 ausgestattet ist, der über meanderförmig ausgebildete Stege 146 mit einem zentrisch angeordneten Flansch 150 verbunden ist. Der Flansch 150 ist über Schraubenbolzen 151 mit dem Substrathalter 5 verbunden, während der äußere Ring 149 an den Drehteller 101 angeschlossen ist. Ein Zapfen 152 sichert die richtige Einbauweise des Substrathalters 5 in den Drehteller 101 und arretiert den Substrathalter 5 gegenüber dem Drehteller 101.

Durch die Membrane 145 wird eine Drehsicherung zwischen diesen.beiden Teilen geschaffen, die sicherstellt, daß beim Anheben des Substrathalters 5 die Greifer 75 in die Zwischenräume der Greifer 3 eingreifen können.

Die Übergabe des Substrats 2 von der ersten Vorrichtung 130 zu der zweiten Vorrichtung 1 gemäß Figur 1 (wie bereits beschrieben) und Figur 6 geschieht in folgenden Arbeitsschritten:

Zuerst wird das Ventil 26 geöffnet und die Einschleuskammer 30 über die Pumpe 48 evakuiert. Hierdurch entsteht Druckgleichheit auf der Ober- und Unterseite des Substrathalters 5. In diesem Stadium nimmt die Membrane 7 die Stellung gemäß Figur 3 ein, wobei die Feder 6 den Hebel bzw. den Greifer 3 nach außen schwenkt und dabei das ihm zugeführte Substrat 2 hält. Hierzu wird zum gleichen Zeitpunkt der Magnet 67 angesteuert und verschwenkt die Greifer 75 in eine geneigt verlaufende Position gemäß Figur 4 (siehe Winkel α), wobei die oberen Enden der Greifer gegen die entsprechenden Anschläge 77 zur Anlage kommen und dabei das Substrat 2 freigeben.

Nun kann ein Stützteller 100 mit dem Substrathalter 5 in die in Figur 6 dargestellte rechte, untere Stellung verschoben werden, wobei gleichzeitig der Teller bzw. Substrathalter 5 über die Membrane bzw. das Verbindungselement 145 nach unten mitgenommen wird, bis der Substrathalter 5 gegen einen Anschlag 140 des Drehtellers 101 anliegt. Nun kann der Substrathalter 5 eine Schwenkbewegung ausführen, ohne daß dabei eine Relativbewegung zwischen Substrathalter 5 und Drehteller 101 auftritt.

Nach diesem Arbeitsablauf nimmt der nächste, in der Zeichnung nicht dargestellte Substrathalter die zuvor beschriebene Position ein, wozu der Stützteller 100 mit dem Substrathalter 5 wieder nach oben gefahren wird, bis er gegen eine Dichtung 121 anliegt und die Einschleuskammer 30 verschlossen wird. Bei diesem Stellvorgang bleibt das Substrat noch so lange in den Greifern 3, bis das Ventil 32 geöffnet und die Einschleuskammer geflutet wird, so daß dann in der Einschleuskammer Atmosphärendruck eintritt. Hierdurch entsteht der bereits erwähnte Differenzdruck zwischen der Ober- und Unterseite des Substrathalters 5, so daß sich die Membrane 7 weiter in den Vakuumraum 4 bewegt und dabei die Greifer 3 aus der in ausgezogenen Linien dargestellten Stellung in die in gestrichelten Linien dargestellte Stellung gemäß Figur 3 verschwenkt. Hierdurch wird das Substrat bzw. die Compact Disk 2 freigegeben. Nun können zum gleichen Zeitpunkt auch die Greifer 75 der oberen Vorrichtung 130 über die Polschuhe angesteuert werden, so daß sie aus ihrer geneigt verlaufenden Lage in ihre vertikal verlaufende Lage gemäß Figur 4 verschwenkt werden und dabei das Substrat 2 erfassen. Jetzt kann das obere Substrat abgehoben werden und durch Schwenken des Greiferträgers 117 das nächste Substrat 2 in die beschriebene Position gebracht werden.

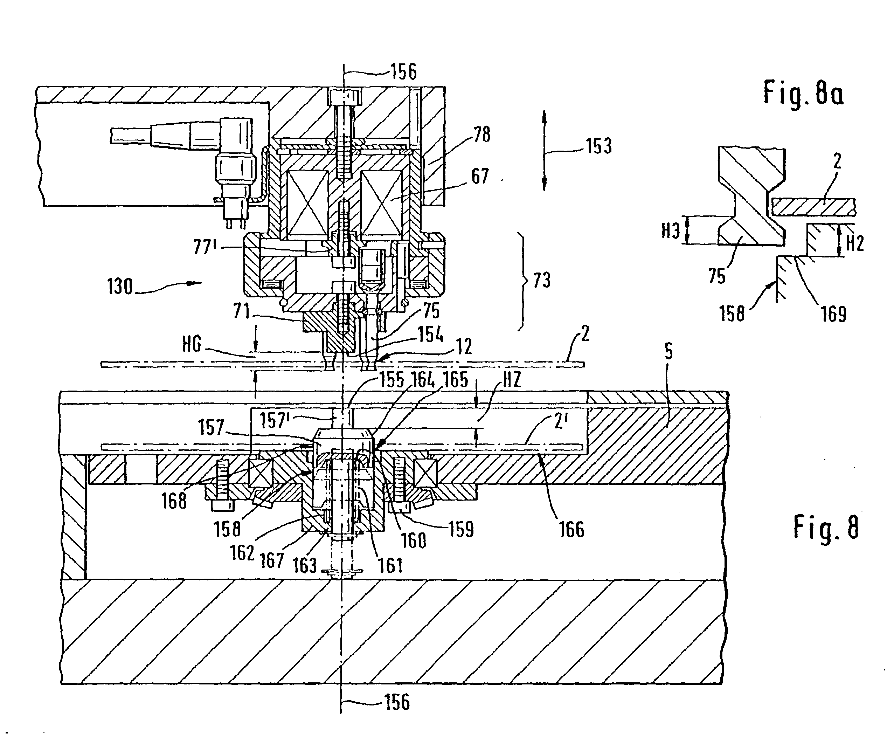

In Fig. 8 ist ein weiteres Ausführungsbeispiel des Substrataufnahmeteils 73 dargestellt, das in der mechanischen und/oder elektromechanischen Stelleinrichtung 130 angeordnet und mittels dieser gemäß Pfeil 153 auf und abwärts bewegt wird, um das Substrat 2' bzw. die CD 2' auf einer Ablagefläche 166 des Substrattellers 5 ablegen oder von ihr aufnehmen zu können (vergl. hierzu Fig. 6 und Fig. 8).

Wird die Stelleinrichtung 130 mit den nach innen verschwenkten Greifern 75 gemäß Pfeil 153 senkrecht nach unten verstellt, so trifft eine am Aufnahmeteil 71 vorgesehene Fläche 154, die zwischen den Greifern 75 liegt, auf eine koaxial zu ihr angeordnete Fläche 155. Die Fläche 155 bildet das obere Abschlußende eines in Längsrichtung einer Mittellinie 156 verstellbaren Zentrierstiftes 157 mit einem sich daran anschließenden Stellstift 157', dessen Außendurchmesser kleiner ist als der Außendurchmesser des Zentrierstiftes 157, so daß er von den in etwa kreisförmig angeordneten Greifern 75 umgriffen werden kann, wenn der Stellstift 157' gegen die Stirnfläche 154 des Aufnahmeteils 71 zur Anlage kommt. Der Zentrierstift 157 ist in einer zylinderförmigen Bohrung 158 eines Gehäuses 167 verstellbar aufgenommen, das mit dem Substrathalter 5 über Schraubenbolzen 159 lösbar verbunden ist.

Der Zentrierstift 157 weist eine untere Stirnfläche bzw. eine Vertiefung 160 auf, in der eine Feder 161 eingesetzt ist, die mit ihrem einen Ende in der Vertiefung 160 und mit ihren anderen Ende gegen einen Boden 163 einer Sacklochbohrung 162 aufsitzt, die in dem Gehäuse 167 vorgesehen ist. Die Feder 161 drückt den Zentrierstift 157 gemäß Pfeil 153 so lange nach oben in eine das Substrat 2 aufnehmende bzw. zentrierende Stellung wie die Fläche 154 nicht gegen die Fläche 155 anliegt.

In vorteilhafter Weise ist das Maß HG (freistehender Teil der Greifer) gemäß Fig. 8 kleiner als das Maß HZ (freistehender Teil des Stellbolzens 157' bzw. des Zentrierstiftes 157). Hierdurch ist es möglich, daß beim Absenken der Stelleinrichtung 130 nur die Stirnfläche 154 des Aufnahmeteils 71 gegen die Stirnfläche 155 des Stellstiftes 157' zur Anlage kommt und diesen in eine zweite, in gestrichelten Linien dargestellte Stellung in Richtung des Pfeils bzw. nach unten verschiebt. Bei diesem Stellvorgang haben die nach innen verschwenkten Greifer 75 die Möglichkeit, in die Bohrung bzw. Öffnung 12 des Substrats 2 einzugreifen und mit ihren Vertiefungen 72 in den Innenrandbereich der Öffnung 12 des Substrats 2 zu gelangen, da der Zentrierstift 157 weiter in die Bohrung 12 hineinbewegt wurde. Die nach innen vertsellten Greifer 75 können sich jetzt nach außen bewegen, das Substrat 2 von unten her erfassen und vom Substratteller 5 aufnehmen.

Nun kann die Stelleinrichtung bzw. der Greiferkopf 130 mit den nach außen verstellten Greifern 75 und einem Subsrat 2 nach oben bewegt und das Substrat einer anderen Bearbeitungsvorrichtung zugeführt werden.

Haben die Substratgreifer 75 von der nächsten Stelleinrichtung bzw. dem Greiferkopf 130 ein neues Substrat 2 aufgenommen, so wird die Stellvorrichtung 130 mit dem Substrat 2 nach unten bewegt und die Stirnfläche 154 drückt den Zentrierstift 157 wieder nach unten, bis das Substrat 2 auf der Ablagefläche 166 des Substrattellers 5 abgelegt werden kann. In der unteren Stellung der Substratgreifer 75 können diese nach innen verschwenkt und das Substrat 2 freigegeben werden, um es auf dem Substratteller 5 abzulegen. Danach bewegt sich die Stelleinrichtung 130 wieder nach oben. Gleichzeitig wird auch der Zentrierstift 157 mittels der Feder 161 nach oben und in die Öffnung bzw. Bohrung 12 des Substrats 2 bewegt, so daß das Substrat 2 gegenüber dem Substratteller 5 zentriert werden kann.

Hierzu schließt sich an das untere Ende des Stellbolzens 157' ein sich nach unten konisch erweiterndes Führungsteil 164 an, das in ein die Bohrung 158 aufweisendes Gehäuse bzw. Zylinderteil 165 übergeht, das Teil des Zentrierstiftes 157 ist. Das von den Greifern 75 abgegebene Substrat 2 gleitet über das Führungsteil 164 auf ein Zylinderteil 168, wenn die Feder 161 den Zentrierstift 157 nach oben bewegt. Hierdurch wird das Substrat 2 automatisch zentriert, falls es gegenüber der Mittellinie 156 seitlich verschoben sein sollte.

Wie aus Fig. 8 hervorgeht ist der Außendurchmesser der kreisförmig angeordneten, nach innen geschwenkten Greifer 75 etwas kleiner als der Innendurchmesser der Bohrung 158, in der der zylinderförmige Zentrierstift 157 verschiebbar aufgenommen ist. Die Bohrung 158 bzw. der Außendurchmesser des Zentrierstiftes 157 ist in etwa so groß wie der Innendurchmesser des Substrats 2, so daß für die Substratübergabe an den Substratteller 5 die Substratgreifer 75 in die Bohrung 12 des Substrats 2 und teilweise auch in die Bohrung 158 des Gehäuses 167 eingefahren werden können.

Wie aus Fig.8a hervorgeht, weist die Bohrung 158 im oberen Bereich eine kreisrunde Erweiterung bzw. Ausnehmung 169 auf, in die das untere Ende der Greifer 75 eingeführt werden können, um das Substrat 2 von unten her zu erfassen. Hierzu ist es vorteilhaft, wenn die Tiefe H₂ der Eindrehung 169 größer ist als die Länge H₃ zwischen der Vertiefung 72 und dem unteren Ende des Greifers 75, damit das Substrat 2 von der Vertiefung 72 des Greifers 75 ohne weiteres erfaßt werden kann.

## Patentansprüche

1. Vorrichtung zum Transport von kreisförmigen, ein Mittelloch aufweisenden, plattenförmigen Substraten (2) zwischen einer ersten Vorrichtung (130) und mindestens einer zweiten Vorrichtung (1) zum Greifen und Halten der Substrate (2), wobei die zweite Vorrichtung (1) in einer Vakuumkammer (4) angeordnet ist und mindestens einen Substrathalter (5) aufweist, wobei die erste Vorrichtung (130) zum Greifen und Halten der Substrate (2) mit mindestens einem verstellbar angeordneten Greifer (75) ausgerüstet ist, der mittels einer mechanischen und/oder elektromechanischen bzw. magnetischen Stelleinrichtung in eine das Substrat (2) haltende oder freigebende Stellung verstellbar ist, **dadurch gekennzeichnet daß** die Stelleinrichtung der ersten Vorrichtung (130) einen Aufnahmeteil (71) mit einer zwischen den Greifern (75) vorgesehenen ersten Fläche (154) aufweist und der das Substrat (2) aufnehmende Substrathalter (5) der zweiten Vorrichtung (1) eine das Substrat (2) ausrichtende Zentriereinrichtung aufweist, wobei die Zentriereinrichtung eine koaxial zur ersten Fläche (154) angeordnete zweite Fläche (155) hat, die ein oberes Abschlußende eines in Längsrichtung einer Mittellinie (156) verstellbaren Zentrierstiftes (157) mit einem sich daran anschließenden Stellstift (157') bildet, wobei der Außendurchmesser des Stellstiftes (157') kleiner ist als der des Zentrierstiftes (157), so daß er vom Greifer (75) umgreifbar ist, wenn die erste und zweite Fläche (154, 153) einander berühren.

2. Vorrichtung nach Anspruch 1, **dadurch gekennzeichnet, daß** die Zentriereinrichtung so ausgebildet ist, daß das Substrat (2) gegenüber der gemeinsamen Mittellinie (156) der beiden Vorrichtungen (1, 130) selbsttätig ausrichtbar ist.

3. Vorrichtung nach Anspruch 1 oder 2, **dadurch gekennzeichnet, daß** die Zentriereinrichtung axial entlang der oder koaxial zur Mittellinie (156) und/oder koaxial zu auf einem Kreisradius angeordneten Substratgreifern (3, 75) verstellbar ist.

4. Vorrichtung nach Anspruch 1, **dadurch gekennzeichnet, daß** die Zentriereinrichtung auf einem Substrathalter (5) und konzentrisch zur Mittellinie (156) der Stelleinrichtung der ersten Vorrichtung (130) und/oder deren kreisförmig gruppierten Greifern (75) angeordnet ist.

5. Vorrichtung nach einem oder mehreren der vorhergehenden Ansprüche, **dadurch gekennzeichnet, daß** der Zentrierstift (157) zylinderförmig ausgebildet ist und gegen die Wirkung eines Stellmittels, vorzugsweise einer Feder (161) in Richtung von der Stelleinrichtung weg verstellbar ist.

6. Vorrichtung nach einem oder mehreren der vorhergehenden Ansprüche, **dadurch gekennzeichnet, daß** die Greifer (75) an der Stelleinrichtung, vorzugsweise an einem daran vorgeschenen Greiferkopf angeordnet sind und ge-genüber der ersten Fläche (154) hervorstehen, deren Abstand HG zu den unteren Enden der Greifer (75) kleiner ist als der Abstand HZ zwischen der zweiten Fläche (155) des Zentrierstiftes (157), und seinem unteren Ende, das außerhalb einer Öffnung (12) des kreisformigen, ein Mitteloch aufweisenden, plattenförmigen Substrats (2) bzw. einer Bohrung (158) im Substrathalter (5) liegt, in der der Zentrierstift (157) verstellbar aufgenommen ist.

7. Vorrichtung nach Anspruch 6, **dadurch gekennzeichnet, daß** das untere Ende oder der aus der Bohrung (158) eines Gehäuses (167) herausstehende Teil des Zentrierstiftes (157) einen sich konisch verjüngenden Führungsteil (164) aufweist, auf dem der Stellbolzen (157') sitzt, der gegen die erste Fläche (154) zur Anlage bringbar ist, die Teil des Aufnahmeteils (71) des Greiferkopfes ist.

8. Vorrichtung nach Anspruch 6 oder 7, **dadurch gekennzeichnet, daß** der Innendurchmesser der nach innen geschwenkten, kreisförmig angeordneten Greifer (75) etwas grösser ist als der Außendurchmesser des Zentrierstiftes (157) und/oder daß der Außendurchmesser der nach innen geschwenkten, kreisförmig angeordneten Greifer (75) etwas kleiner als der Innendurchmesser der Bohrung (158) in der der Zentrierstift (157) verstellbar aufgenommen ist.

9. Vorrichtung nach einem oder mehreren der Ansprüche 6 bis 8, **dadurch gekennzeichnet, daß** die Feder (161) zum Verstellen des Zentrierstiftes (157) in der Bohrung (158) aufgenommen ist, in der der Zentrierstift (157) verschiebbar gelagert ist.

10. Vorrichtung nach einem oder mehreren der Ansprüche 6 bis 9, **dadurch gekennzeichnet, daß** die Bohrung (158) eine derartige Länge aufweist, daß der zylinderförmige Teil (168) der Zentriervorrichtung soweit in die Bohrung (158) einschiebbar ist, daß die Greifer (75) in die offnung (12) des Substrats (2) eingefahren werden können, um dieses vom Substratteller (5) aufzunehmen und/oder auf diesem abzulegen.

11. Vorrichtung nach einem oder mehreren der vorhergehenden Ansprüche, **dadurch gekennzeichnet, daß** nach koaxialer Ausrichtung und bei vakuumdichter Anlage der beiden Vorrichtungen (1, 130) der Druck in der Einschleuskammer (30) abgesenkbar und das über die erste Vorrichtung (130) an die zweite Vorrichtung (1) abgegebene Substrat (2) mittels der zweiten Vorrichtung (1) über den nun freiwerdenden Federdruck haltbar ist.

12. Vorrichtung nach einem oder mehreren der vorhergehenden Ansprüche, **dadurch gekennzeichnet, daß** zwischen einem Drehteller (101) der zweiten Vorrichtung (1) und einem Substrathalter (5) ein einen Hub zulassendes, federelastisches Verbindungselement (145) vorgesehen ist.

13. Vorrichtung nach Anspruch 12, **dadurch gekennzeichnet, daß** das Verbindungselement (145) aus einem mittleren Flansch besteht, der über Verbindungselemente (147) mit dem Substrathalter (5) und über elastische Stege (146) mit dem Drehteller (101) verbunden ist.

14. Vorrichtung nach einem oder mehreren der vorhergehenden Ansprüche, **dadurch gekennzeichnet, daß** die der ersten Vorrichtung (130) zugeordneten Greifer (75) mittels eines Stellelements, vorzugsweise mittels eines Magnets (67) und/oder Federelementen um eine Achse (83) zwischen einer das Substrat (2) haltenden und einer das Substrat (2) freigebenden Stellung verschwenkbar sind.

15. Vorrichtung nach einem oder mehreren der vorhergehenden Ansprüche, **dadurch gekennzeichnet, daß** die der ersten Vorrichtung (130) zugeordneten Greifer (75) um eine Achse (83) schwenkbar sind, die die Längsachse (88) des Greifers (75) oder des Gehäuses (78) in einem annähernd rechten Winkel schneidet.

16. Vorrichtung nach einem oder mehreren der vorhergehenden Ansprüche, **dadurch gekennzeichnet, daß** die der ersten Vorrichtung (130) zugeordneten Greifer (75) bereits beim Fluten einer Einschleußkammer (30) ansprechbar und die Greifer (3) der zweiten Vorrichtung (1) über den E-Magneten in eine Aufnahmestellung verstellbar sind.

17. Vorrichtung nach einem oder mehreren der vorhergehenden Ansprüche, **dadurch gekennzeichnet, daß** zwei oder mehrere mit Abstand zueinander angeordnete Greifer (75) der ersten Vorrichtung (130) so ausgebildet sind, daß sie bei der Substratübergabe in Zwischenräume (148) der ebenfalls mit Abstand zueinander angeordneten Greifer (3) der zweiten Vorrichtung (1) eingreifen.

18. Vorrichtung nach einem oder mehreren der vorhergehenden Ansprüche, **dadurch gekennzeichnet, daß** die Greifer (3 oder 75) im Bereich ihres einen Endes in Langlochöffnungen (93) geführt sind und im Bereich ihres anderen Endes in einem Zylindergehäuse (81) mindestens einen Dauermagneten (80) aufweisen, der mit einem Ringmagneten (67) zusammenwirkt.

19. Vorrichtung nach Anspruch 18, **dadurch gekennzeichnet, daß** das Zylindergehäuse (81) dünnwandig ausgebildet ist und eine Wandstärke zwischen 0,2 mm und 1,0 mm, bevorzugt 0,3 mm und 0,7 mm, stärker bevorzugt 0,4 mm und 0,6 mm aufweist.

20. Vorrichtung nach einem oder mehreren der vorhergehenden Ansprüche, **dadurch gekennzeichnet, daß** die Greifer (75) in einem elastischen Ringlager (84) schwenkbar aufgenommen und im Bereich ihres oberen Endes zwischen magnetisierbaren Anschlägen (77, 77') verstellbar sind.

21. Vorrichtung nach einem oder mehreren der vorhergehenden Ansprüche, **dadurch gekennzeichnet, daß** eine einem in etwa konstanten Vakuumdruck Pᵥ auf einer Seite (10) ausgesetzte Membrane (7) über einen Differenzdruck P_{d} = Pₐ - Pᵥ steuerbar ist, der dann auftritt, wenn die Kammer (30, 4' 4'') zur Aufnahme des Substrats (2) geflutet ist.

22. Vorrichtung nach Anspruch 21 **dadurch gekennzeichnet, daß** die Membrane (7) so ausgebildet ist, daß sie über den Atmosphären-, Vakuumdruck und/oder einen Differenzdruck P_{d}, der sich aus dem Atmosphärendruck Pₐ in der Einschleuskammer (30) abzüglich des Vakuumdrucks Pᵥ in der Vakuumkammer (4) ergibt, steuerbar ist.

23. Vorrichtung nach Anspruch 21 oder 22, **dadurch gekennzeichnet, daß** die in der Vakuumkammer (4) angeordnete Membrane (7) aus einem flexiblen (11) und einem nicht flexiblen Teil (11'), vorzugsweise einem Metallteil oder Teller gebildet ist.

24. Vorrichtung nach Ansprüch 23, **dadurch gekennzeichnet, daß** der nicht flexible Teil (11') mit dem flexiblen Teil (11) der Membrane (7) fest verbunden ist.

25. Vorrichtung nach Anspruch 23 oder 24, **dadurch gekennzeichnet, daß** der nicht flexible Teil (11') als kreisrunder Teller ausgebildet ist, der eine Öffnung (12) der Membrane (7) abdeckt.

26. Vorrichtung nach einem oder mehreren der Ansprüche 23 bis 25, **dadurch gekennzeichnet, daß** der flexible Teil (11) der Membrane (7) mit seinem äußeren Rand (13) an einen Flansch (14') der Vorrichtung (1) und mit einem innenliegenden Rand (15) an einen Rand (51) der im Teller (11') vorgesehenen Öffnung (12) fest angeschlossen ist.

27. Vorrichtung nach einem oder mehreren der Ansprüche 21 bis 26, **dadurch gekennzeichnet daß** die Membrane (7) und der Teller (11') so ausgebilder sind, daß sie die einem ständigen Vakuumdruck Pᵥ ausgesetzte Vakuumkammer (4) gegenüber der einem Atmosphärendruch Pₐ aussetzbaren Vakuumkammer (4') und/oder Einschleuskammer (30) abdichten.

28. Vorrichtung nach Ansprüch 26 oder 27, **dadurch gekennzeichnet, daß** der äußere Rand (13) der Membrane (7) in mindestens einer zwischen dem Flansch (14') und dem Außenteil des Substrathalters (5) vorgesehenen Nut (17, 17') einklemmbar und sicherbar ist.

29. Vorrichtung nach einem oder mehreren der Ansprüche 25 bis 28, **dadurch gekennzeichnet, daß** der Teller (11) über einen koaxialen Zapfen (19) mit einem zylinderförmigen Teil (18) verbunden, vorzugsweise verschraubt ist, das auf einem mit einem ebenfalls koaxial angeordneten Flansch (14') verbundenen Zapfen (20) geführt ist.

30. Vorrichtung nach Ansprüch 29, **dadurch gekennzeichnet, daß** das zylinderförmige Teil (18) mit einem Stellteil (8) fest verbunden ist.

31. Vorrichtung nach Ansprüch 30, **dadurch gekennzeichnet, daß** das Stellteil (8) im Bereich seines einen Endes (21) gegen einen oder mehrere Greifer (3) anliegt.

32. Vorrichtung nach Ansprüch 31, **dadurch gekennzeichnet, daß** das zylinderförmige Teil (18) mit seinem einen oder zweiten Ende oder seinem Teller (11') gegen einen feststehenden Flansch (22) und mit seinem ersten oder anderen Ende oder Stellteil (8) gegen den Greifer (3) und/oder einen Hebelarm (57) des Greifers (3) anlegbar ist.

33. Vorrichtung nach einem oder mehreren der Ansprüche 21 bis 32, **dadurch gekennzeichnet, daß** die Membrane (7) bei auftretendem Differenzdruck P_{d} weiter in die Vakummkammer (4) bewegbar ist und dadurch der oder die Greifer (3) vom Bohrungsrand (62) des Substrats (2) wegbewegbar und diesen freigebbar ist.

34. Vorrichtung nach Ansprüch 32 oder 33, **dadurch gekennzeichnet, daß** der feststehende Flansch (22) mit dem Flansch (14') der Vorrichtung (1) mittel- oder unmittelbar fest verbunden ist.

35. Vorrichtung nach einem oder mehreren der Ansprüche 32 bis 34, **dadurch gekennzeichnet, daß** der feststehende Flansch (22) eine zylinderförmige Verlängerung (23) aufweist, in der die Feder (6) aufgenommen ist.

36. Vorrichtung nach einem oder mehreren der Ansprüche 32 bis 35, **dadurch gekennzeichnet, daß** zwischen dem Flansch (14') der Vorrichtung (1) und dem feststehenden Flansch (22) ein Tragteil (24) zur verschwenkbaren Aufnahme der Greifer (3) vorgesehen ist.

37. Vorrichtung nach einem oder mehreren der Ansprüche 32 bis 36, **dadurch gekennzeichnet, daß** der feststehende Flansch (22) und das Tragteil (24) über die gleichen Verbindungselemente (25) mit dem Flansch (14') der Vorrichtung (1) lösbar verbunden sind.

38. Vorrichtung nach einem oder mehreren der Ansprüche 21 bis 37, **dadurch gekennzeichnet, daß** die oberhalb der Membrane (7) liegende Vakuumkammer (4') und/oder die Einschleuskammer (30) über eine erste Vakuumpumpe (48) evakuierbar und über eine weitere Einrichtung (32) flutbar und die unterhalb der Membrane (7) liegende Vakuumkammer (4) über eine zweite Vakuumpumpe (27) evakuierbar ist, wobei die beiden Vakuumpumpen (48, 27) und/oder die zugehörigen Ventile derart steuerbar sind, daß der Differenzdruck P_{d} auf annähernd Null herabsenkbar ist.

39. Vorrichtung nach Ansprüch 38, **dadurch gekennzeichnet, daß** durch die Ausbildung der oberen Vakuumkammer (4'), die über eine Einrichtung bzw. über ein Steuerventil (32) flutbar ist, die Greifer (3) zwangsweise sofort verstellbar sind

40. Vorrichtung nach einem oder mehreren der vorhergehenden Ansprüche, **dadurch gekennzeichnet, daß** der Greifer (3) ein Zugteilaufweist, über das er verstellbar ist, wenn der Stelldruck dem Atmosphärendruck Pₐ entspricht.

41. Vorrichtung nach einem oder mehreren der vorhergehenden Ansprüche, **dadurch gekennzeichnet, daß** die Greifer (3) so ausgebilder sind, daß sie sich, auf der Seite befinden, auf der sich ein Druck einstellt, der höher ist als der Vakuumdruck Pᵥ.

## Claims

1. An apparatus for transporting circular, plate-shaped substrates (2) having a center hole between at least a first device (130) and at least a second device (1) for gripping and holding the substrates (2), wherein the second device (1) is arranged in a vacuum chamber (4) and comprises at least one substrate support (5), wherein the first device (130) for gripping and holding the substrates (2) comprises at least one controllably arranged gripper (75) which can be controlled by means of a mechanical and/or electromechanically or magnetically operating positioning device between a substrate (2) gripping position and a substrate (2) release position, **characterized in that** the positioning device of the first device (130) comprises a receiving part (71) with a first surface (154) located between the grippers (75), and the substrate support (5) of the second device (1), which receives the substrate (2), comprises a centering means for aligning the substrate (2), wherein the centering means has a second surface (155) being arranged coaxially with respect to the first surface (154) and forming an upper end of a centering pin (157), said centering pin (157) being displaceable in the longitudinal direction of a center line (156) and comprising a control pin (157') projecting from the centering pin (157), wherein the outer diameter of the control pin (157') is smaller than that of the centering pin (157) so that it can be gripped by the gripper (75) when the first and second surfaces (154, 153) contact each other.

2. The apparatus according to claim 1, **characterized in that** the centering means is formed such that the substrate (2) is self-alignable with respect to the common center axis (156) of the two devices (1, 130).

3. The apparatus according to claim 1 or 2, **characterized in that** the centering means can be displaced axially along or coaxially with the center line (156) and/or coaxially with substrate grippers (3, 75) arranged on a circle.

4. The apparatus according to claim 1, **characterized in that** the centering means is arranged on a substrate support (5) and concentrically with the center line (156) of the adjusting device of the first device (130) and/or its circularly arranged grippers (75).

5. The apparatus according to one or more of the previous claims, **characterized in that** the centering pin (157) is shaped cylindrically and is displaceable against the effect of a positioning means, preferably a spring (161), in the direction away from the positioning device.

6. The apparatus according to one or more of the previous claims, **characterized in that** the grippers (75) are disposed on the positioning device, preferably on a gripper head provided thereon, and project beyond the first surface (154) whose distance HG from the lower ends of the grippers (75) is smaller than the distance HZ between the second surface (155) of the centering pin (157) and its lower end, which lies outside an opening (12) of the circular, plate-shaped substrate (2) having a center hole or a bore (158) in the substrate support (5) in which the centering pin (157) is displaceably mounted.

7. The apparatus according to claim 6, **characterized in that** the lower end or the part of the centering pin (157) which projects from the bore (158) of a housing (167) has a conically tapering guide element (164) on which the positioning bolt (157') is located, wherein the positioning bold (157') can be brought in contact with the first surface (154) which forms part of the receiving part (71) of the gripper head.

8. The apparatus according to claim 6 or 7, **characterized in that** the inner diameter of the circularly arranged grippers (75), which are swiveled inwardly, is slightly larger than the outer diameter of the centering pin (157) and/or that the outer diameter of the circularly arranged grippers (75), which are swiveled inwardly, is slightly smaller than the inner diameter of the bore (158) in which the centering pin (157) is displaceably mounted.

9. The apparatus according to one or more of claims 6 to 8, **characterized in that** the spring (161) for displacing the centering pin (157) is located in the bore (158) in which the centering pin (157) is displaceably mounted.

10. The apparatus according to one or more of claims 6 to 9, **characterized in that** the bore (158) is of such a length that the cylindrical part (168) of the centering device can be pushed into the bore (158) by an amount sufficient to allow the grippes (75) to be moved into the opening (12) of the substrate (2) in order to lift it off and/or place it on the substrate support (5).

11. The apparatus according to one or more of the preceding claims, **characterized in that** after a coaxial alignment and with a vacuum-tight connection between the two devices (1, 130), the pressure in the infeed chamber (30) can be lowered and the substrate (2) transferred from the first device (130) to the second device (1) can be held by the second device (1) by means of the now released spring pressure.

12. The apparatus according to one or more of the preceding claims, **characterized in that** a spring-elastic connecting element (145) that allows a stroke is provided between a turntable (101) of the second device (1) and a substrate support (5).

13. The apparatus according to claim 12, **characterized in that** the connecting element (145) consists of a central flange which is connected via connecting elements (147) with the substrate support (5) and via elastic bars (146) with the turntable (101).

14. The apparatus according to one or more of the preceding claims, **characterized in that** the grippers (75) associated with the first device (130) are pivotable by means of a positioning element, preferably by means of a magnet (67) and/or spring elements, around an axis (83) between a substrate (2) gripping position and a substrate (2) release position.

15. The apparatus according to one or more of the preceding claims, **characterized in that** the grippers (75) associated with the first device (130) are pivotable around an axis (83) that intersects the longitudinal axis (88) of the gripper (75) or the housing (78) in an approximately right-angled manner.

16. The apparatus according to one or more of the preceding claims, **characterized in that** the grippers (75) associated with the first device (130) are responsible already after flooding an infeed chamber (30) and the grippers (3) of the second device (1) are displaceable into a receiving position by means of the electromagnet.

17. The apparatus according to one or more of the preceding claims, **characterized in that** two or more of the grippers (75) of the first device (130), which are spaced from one another, are shaped such that during substrate transfer they engage in gaps (148) between the grippers (3) of the second device (1), which are also spaced from one another.

18. The apparatus according to one or more of the preceding claims, **characterized in that** in the area of one of their ends the grippers (3 or 75) extend through elongated openings (93) and in the area of the other one of their ends they comprise at least one permanent magnet (80) which cooperates with a ring magnet (67) in a cylinder housing (81).

19. The apparatus according to claim 18, **characterized in that** the cylinder housing (81) has thin walls with a wall thickness between 0.2 mm and 1.0 mm, preferably 0.3 mm and 0.7 mm, more preferably 0.4 mm and 0.6 mm.

20. The apparatus according to one or more of the preceding claims, **characterized in that** the grippers (75) are pivotably received in an elastic annular bearing (84) and the upper ends of the grippers (75) are displaceable between magnetizable stops (77, 77').

21. The apparatus according to one or more of the preceding claims, **characterized in that** a diaphragm (7), one side (10) of which is subjected to an approximately constant vacuum pressure Pᵥ, can be controlled via a differential pressure P_{d} = Pₐ - Pᵥ which occurs when the chamber (30, 4', 4") is flooded for receiving the substrate (2).

22. The apparatus according to claim 21, **characterized in that** the diaphragm (7) is formed such that it is controllable via the atmospheric pressure, vacuum pressure and/or a differential pressure P_{d} which results from the atmospheric pressure Pₐ in the infeed chamber (30) minus the vacuum pressure Pᵥ in the vacuum chamber (4).

23. The apparatus according to claim 21 or 22, **characterized in that** the diaphragm (7), which is arranged in the vacuum chamber (4), consists of a flexible part (11) and a non-flexible part (11'), preferably a metal part or a plate.

24. The apparatus according to claim 23, **characterized in that** the non-flexible part (11') is firmly joined to the flexible part (11) of the diaphragm (7).

25. The apparatus according to claim 23 or 24, **characterized in that** the non-flexible part (11') is formed as a circular plate which covers an opening (12) of the diaphragm (7).

26. The apparatus according to one or more claims 23 to 25, **characterized in that** the outer edge (13) of the flexible part (11) of the diaphragm (7) is firmly connected to a flange (14') of the device (1) and an inner edge (15) of the flexible part (11) of the diaphragm (7) is firmly connected to an edge (51) of the opening (12) in the plate (11').

27. The apparatus according to one or more of claims 21 to 26, **characterized in that** the diaphragm (7) and the plate (11') are formed such that they seal the chamber (4), which is subjected to a permanent vacuum pressure Pᵥ, against a vacuum chamber (4') and/or infeed chamber (30), which can be subjected to atmospheric pressure Pₐ.

28. The apparatus according to claim 26 or 27, **characterized in that** the outer edge (13) of the diaphragm (7) can be clamped and secured in at least one groove (17, 17') provided between the flange (14') and the outer part of the substrate support (5).

29. The apparatus according to one or more of claims 25 to 28, **characterized in that** the plate (11) is connected, preferably screwed, via a coaxial pin (19) to a cylindrical part (18) which is guided on a pin (20) which is connected to an also coaxially arranged flange (14').

30. The apparatus according to claim 29, **characterized in that** the cylindrical part (18) is firmly connected to an adjusting element (8).

31. The apparatus according to claim 30, **characterized in that** in the area of its one end (21) the adjusting element (8) abuts one or more gripper(s) (3).

32. The apparatus according to claim 31, **characterized in that** the one or second end or the plate (11') of the cylindrical part (18) can abut a stationary flange (22) and that the first or other end or the adjusting element (8) of the cylindrical part (18) can abut the gripper (3) and/or a lever arm (57) of the gripper (3).

33. The apparatus according to one or more of claims 21 to 32, **characterized in that** if a difference pressure P_{d} occurs, the diaphragm (7) can be moved further into the vacuum chamber (4) and thus the gripper(s) (3) can be moved away from the edge (62) of the bore of the substrate (2) and thus release the edge (62) of the bore of the substrate (2).

34. The apparatus according to claim 32 or 33, **characterized in that** the stationary flange (22) is directly or indirectly firmly connected to the flange (14') of the device (1).

35. The apparatus according to one or more of claims 32 to 34, **characterized in that** the stationary flange (22) has a cylindrical extension (23) in which the spring (6) is received.

36. The apparatus according to one or more of claims 32 to 35, **characterized in that** a support part (24) for pivotably receiving the grippers (3) is provided between the flange (14') of the device (1) and the stationary flange (22).

37. The apparatus according to one or more of claims 32 to 36, **characterized in that** the stationary flange (22) and the support part (24) are detachably connected to the flange (14') of the device (1) via the same connecting elements (25).

38. The apparatus according to one or more of claims 21 to 37, **characterized in that** the vacuum chamber (4') lying above the diaphragm (7) and/or the infeed chamber (30) can be evacuated via a first vacuum pump (48) and flooded via a further device (32) and that the vacuum chamber (4) lying below the diaphragm (7) can be evacuated via a second vacuum pump (27), wherein the two vacuum pumps (48, 27) and/or the respective valves can be controlled such that the differential pressure P_{d} can be lowered to approximately zero.

39. The apparatus according to claim 38, **characterized in that** due to the arrangement of the upper vacuum chamber (4'), which can be flooded via a device or via a control valve (32), the grippers (3) are compulsorily immediately displaceable.

40. The apparatus according to one or more of the preceding claims, **characterized in that** the gripper (3) comprises a tension part via which it is displaceable if the control pressure corresponds to the atmospheric pressure Pₐ.

41. The apparatus according to one or more of the preceding claims, **characterized in that** the grippers (3) are formed such that they are on the side on which a pressure occurs which is higher than the vacuum pressure Pᵥ.

## Revendications

1. Dispositif de transport de substrats (2) circulaires plats, munis d'un trou central, entre un premier dispositif (130) et au moins un deuxième dispositif (1) destiné à saisir et retenir les substrats (2), le deuxième dispositif (1) étant monté dans une chambre à vide (4) et étant muni d'au moins un support pour substrat (5), le premier dispositif (130) destiné à saisir et retenir les substrats (2) étant équipé d'au moins une griffe (75) agencée de façon mobile, qui peut être commandée au moyen d'un dispositif de réglage mécanique et/ou électromécanique ou magnétique dans une position saisissant ou libérant le substrat (2), **caractérisé en ce que** le dispositif de réglage du premier dispositif (130) comporte un organe de réception (71) avec une première surface (154) prévue entre les griffes (75), et le support pour substrat (5) du deuxième dispositif (1), destiné à recevoir le substrat (2), comporte un organe de centrage destiné à orienter le substrat (2), l'organe de centrage étant muni d'une deuxième surface (155), qui est disposée coaxialement par rapport à la première surface (154) et qui forme une extrémité finale supérieure d'une goupille de centrage (157), susceptible d'être déplacée dans le sens longitudinal d'une ligne médiane (156) et munie d'une pointe de réglage (157') qui s'y raccorde, le diamètre extérieur de la pointe de réglage (157') étant inférieur à celui de la goupille de centrage (157), de telle sorte qu'elle ne peut pas être saisie par la griffe (75) lorsque la première et la deuxième surface (154, 153) sont en contact l'une avec l'autre.

2. Dispositif selon la revendication 1, **caractérisé en ce que** l'organe de centrage est conçu de telle sorte que le substrat (2) est susceptible de s'orienter automatiquement par rapport à la ligne médiane (156) des deux dispositifs (1, 130).

3. Dispositif selon la revendication 1 ou 2, **caractérisé en ce que** l'organe de centrage peut être déplacé dans le sens axial le long de la ligne médiane (156) ou dans le sens coaxial par rapport à celle-ci et/ou dans le sens coaxial par rapport à des griffes pour substrat (3, 75), disposées sur un rayon de cercle.

4. Dispositif selon la revendication 1, **caractérisé en ce que** l'organe de centrage est disposé sur un support pour substrat (5) et concentriquement par rapport à la ligne médiane (156) de l'unité de réglage du premier dispositif (130) et/ou par rapport aux griffes (75) de celles-ci groupées en forme de cercle.

5. Dispositif selon l'une ou plusieurs des revendications précédentes, **caractérisé en ce que** la goupille de centrage (157) est conçue sous forme cylindrique et peut être déplacée dans le sens s'écartant de l'unité de réglage à l'encontre de l'action d'un moyen de réglage, de préférence un ressort (161).

6. Dispositif selon l'une ou plusieurs des revendications précédentes, **caractérisé en ce que** les griffes (75) sont montées sur l'unité de réglage, de préférence sur une tête preneuse prévue sur celle-ci, et s'avancent en saillie par rapport à la première surface (154), dont la distance (HG) avec les extrémités inférieures des griffes (75) est inférieure à la distance (HZ) entre la deuxième surface (155) de la goupille de centrage (157) et son extrémité inférieure, qui est située en dehors d'un orifice (12) du substrat (2), circulaire plat et muni d'un trou central, ou en dehors d'une forure (158) réalisée dans le support pour substrat (5) et destinée à recevoir de manière mobile la goupille de centrage (157).

7. Dispositif selon la revendication 6, **caractérisé en ce que** l'extrémité inférieure ou la partie de la goupille de centrage (157) en saillie hors de la forure (158) d'un boîtier (167) est munie d'une partie de guidage (164) se rétrécissant en forme de cône, sur laquelle est ménagée la pointe de réglage (157') qui peut être amenée en contact contre la première surface (154), qui constitue la partie de l'organe de réception (71) de la tête preneuse.

8. Dispositif selon la revendication 6 ou 7, **caractérisé en ce que** le diamètre intérieur des griffes (75), disposées en forme de cercle et basculées vers l'intérieur, est quelque peu supérieur au diamètre extérieur de la goupille de centrage (157) et/ou **en ce que** le diamètre extérieur des griffes (75), disposées en forme de cercle et basculées vers l'intérieur, est quelque peu inférieur au diamètre intérieur de la forure (158) destinée à recevoir de manière mobile la goupille de centrage (157).

9. Dispositif selon l'une ou plusieurs des revendications 6 à 8, **caractérisé en ce que** le ressort (161) destiné à déplacer la goupille de centrage (157) est monté dans la forure (158), dans laquelle est logée de manière mobile la goupille de centrage (157).

10. Dispositif selon l'une ou plusieurs des revendications 6 à 9, **caractérisé en ce que** la forure (158) présente une longueur telle que la partie cylindrique (168) de l'organe de centrage peut être insérée dans la forure (158) jusqu'au niveau auquel les griffes (75) peuvent être introduites dans l'orifice (12) du substrat (2), afin de saisir et/ou de déposer celui-ci sur le disque support pour substrat (5).

11. Dispositif selon l'une ou plusieurs des revendications précédentes, **caractérisé en ce que**, après l'orientation coaxiale et en présence d'un contact étanche au vide entre les deux dispositifs (1, 130), la pression peut être diminuée dans la chambre formant sas (30), et le substrat (2), transféré sur le deuxième dispositif (1) par l'intermédiaire du premier dispositif (130), peut être retenu par la pression du ressort libéré maintenant.

12. Dispositif selon l'une ou plusieurs des revendications précédentes, **caractérisé en ce que**, entre un disque rotatif (101) du deuxième dispositif (1) et un support pour substrat (5), il est prévu un élément de liaison (145) flexible permettant un mouvement.

13. Dispositif selon la revendication 12, **caractérisé en ce que** l'élément de liaison (145) est formé par une bride centrale, qui est reliée au support pour substrat (5) par l'intermédiaire d'éléments de liaison (147) et avec le disque rotatif (101) par l'intermédiaire de nervures flexibles (146).

14. Dispositif selon l'une ou plusieurs des revendications précédentes, **caractérisé en ce que** les griffes (75) associées au premier dispositif (130) peuvent pivoter, au moyen d'un élément de réglage, de préférence au moyen d'un aimant (67) et/ou de ressorts, autour d'un axe (83) entre une position saisissant le substrat (2) et une position libérant le substrat (2).

15. Dispositif selon l'une ou plusieurs des revendications précédentes, **caractérisé en ce que** les griffes (75) associées au premier dispositif (130) peuvent pivoter autour d'un axe (83), qui coupe pratiquement à angle droit l'axe longitudinal (88) de la griffe (75) ou du boîtier (78).

16. Dispositif selon l'une ou plusieurs des revendications précédentes, **caractérisé en ce que** les griffes (75) associées au premier dispositif (130) peuvent être activées déjà au moment du remplissage d'une chambre formant sas (30) et les griffes (3) du deuxième dispositif (1) peuvent être réglées dans une position de réception par l'intermédiaire des électroaimants.

17. Dispositif selon l'une ou plusieurs des revendications précédentes, **caractérisé en ce que** deux ou plusieurs griffes (75) du premier dispositif (130), écartées les unes des autres, sont conçues de telle sorte que, au moment du transfert du substrat, elles entrent en prise dans des intervalles (148) compris entre les griffes (3) du deuxième dispositif (1), également écartées les unes des autres.

18. Dispositif selon l'une ou plusieurs des revendications précédentes, **caractérisé en ce que** les griffes (3 ou 75) sont guidées dans la zone de l'une de leurs extrémités dans des trous oblongs (93) et sont munies dans la zone de leur autre extrémité d'au moins un aimant permanent (80), situé dans un boîtier cylindrique (81) et qui agit conjointement avec un aimant torique (67).

19. Dispositif selon la revendication 18, **caractérisé en ce que** le boîtier cylindrique (81) comporte des parois minces, avec une épaisseur comprise entre 0,2 mm et 1,0 mm, de préférence entre 0,3 mm et 0,7 mm, de manière davantage préférée entre 0,4 mm et 0,6 mm.

20. Dispositif selon l'une ou plusieurs des revendications précédentes, **caractérisé en ce que** les griffes (75) sont disposées de manière à pouvoir pivoter dans un logement circulaire (84) élastique et peuvent être déplacées dans la zone de leur extrémité supérieure entre des butées (77, 77') magnétisables.

21. Dispositif selon l'une ou plusieurs des revendications précédentes, **caractérisé en ce qu'**une membrane (7), dont une face (10) est exposée à une pression sous vide (Pᵥ) pratiquement constante, peut être commandée par l'intermédiaire d'une pression différentielle (P_{d} = Pₐ - Pᵥ), qui est générée lorsque la chambre (30, 4', 4''), destinée à recevoir le substrat (2), est remplie.

22. Dispositif selon la revendication 21, **caractérisé en ce que** la membrane (7) est conçue de telle sorte qu'elle peut être commandée par l'intermédiaire de la pression atmosphérique, de la pression sous vide et/ou d'une pression différentielle (P_{d}), qui est égale à la pression atmosphérique (Pₐ), qui règne dans la chambre (30), moins la pression sous vide (Pᵥ), qui règne dans la chambre à vide (4).

23. Dispositif selon la revendication 21 ou 22, **caractérisé en ce que** la membrane (7) disposée dans la chambre à vide (4) est formée par une partie flexible (11) et une partie non flexible (11'), de préférence une partie métallique ou un disque.

24. Dispositif selon la revendication 23, **caractérisé en ce que** la partie non flexible (11') est assemblée de manière inamovible avec la partie flexible (11) de la membrane (7).

25. Dispositif selon la revendication 23 ou 24, **caractérisé en ce que** la partie non flexible (11') est conçue sous forme de disque circulaire, qui recouvre un orifice (12) de la membrane (7).

26. Dispositif selon l'une ou plusieurs des revendications 23 à 25, **caractérisé en ce que** la partie flexible (11) de la membrane (7) est assemblée de manière inamovible avec son bord extérieur (13) sur une bride (14') du dispositif (1) et avec son bord intérieur (15) sur un bord (51) de l'orifice (12) prévu dans le disque (11').

27. Dispositif selon l'une ou plusieurs des revendications 21 à 26, **caractérisé en ce que** la membrane (7) et le disque (11') sont conçus de manière à rendre étanche la chambre à vide (4), exposée à une pression sous vide (Pᵥ) constante, par rapport à la chambre à vide (4') et/ou la chambre formant sas (30) susceptible d'être exposées à une pression atmosphérique (Pₐ).

28. Dispositif selon la revendication 26 ou 27, **caractérisé en ce que** le bord extérieur (13) de la membrane (7) peut être bloqué et protégé dans au moins une gorge (17, 17') prévue entre la bride (14') et la partie extérieure du support pour substrat (5).

29. Dispositif selon l'une ou plusieurs des revendications 25 à 28, **caractérisé en ce que** le disque (11) est assemblé, de préférence par vissage, par l'intermédiaire d'un pivot coaxial (19) avec une partie cylindrique (18), qui est guidée sur un pivot (20) relié à une bride (14') également disposée dans le sens coaxial.

30. Dispositif selon la revendication 29, **caractérisé en ce que** la partie cylindrique (18) est reliée de manière inamovible avec un organe de réglage (8).

31. Dispositif selon la revendication 30, **caractérisé en ce que** l'organe de réglage (8), dans la zone de l'une de ses extrémités (21) est en appui contre une ou plusieurs griffes (3).

32. Dispositif selon la revendication 31, **caractérisé en ce que** la partie cylindrique (18) peut venir en appui avec l'une ou sa deuxième extrémité ou son disque (11') contre une bride fixe (22) et avec sa première ou son autre extrémité ou l'organe de réglage (8) contre la griffe (3) et/ou un bras de levier (57) de la griffe (3).

33. Dispositif selon l'une ou plusieurs des revendications 21 à 32, **caractérisé en ce que** la membrane (7), au moment de l'apparition de la pression différentielle (P_{d}), peut être déplacée davantage dans la chambre à vide (4) et, de ce fait, la ou les griffes (3) s'écartent du bord de la forure (62), réalisée dans le substrat (2), et libèrent celui-ci.

34. Dispositif selon la revendication 32 ou 33, **caractérisé en ce que** la bride (22) fixe est reliée de manière inamovible directement ou indirectement à la bride (14') du dispositif (1).

35. Dispositif selon l'une ou plusieurs des revendications 32 à 34, **caractérisé en ce que** la bride fixe (22) est munie d'un prolongement cylindrique (23), dans lequel est logé le ressort (6).

36. Dispositif selon l'une ou plusieurs des revendications 32 à 35, **caractérisé en ce que**, entre la bride (14') du dispositif (1) et la bride fixe (22), il est prévu un élément de support (24) destiné à recevoir la griffe (3) de manière à pouvoir pivoter.

37. Dispositif selon l'une ou plusieurs des revendications 32 à 36, **caractérisé en ce que** la bride fixe (22) et l'élément de support (24) sont reliés de manière amovible à la bride (14') du dispositif (1), au moyen des mêmes éléments de liaison (25).

38. Dispositif selon l'une ou plusieurs des revendications 21 à 37, **caractérisé en ce que** dans la chambre à vide (4'), située au-dessus de la membrane (7), et/ou la chambre formant sas (30) peuvent être mises sous vide par l'intermédiaire d'une première pompe à vide (48) et être remplies par l'intermédiaire d'une autre unité (32), et la chambre à vide (4), située au-dessous de la membrane (7), peut être mise sous vide par l'intermédiaire d'une deuxième pompe à vide (27), les deux pompes à vide (48, 27) et/ou les vannes associées pouvant être commandées de manière telle que la pression différentielle (P_{d}) peut être abaissée pratiquement à zéro.

39. Dispositif selon la revendication 38, **caractérisé en ce que** la conception de la chambre à vide (4') supérieure, laquelle peut être remplie par une unité ou par une vanne pilote (32), permet de faire en sorte que les griffes (3) peuvent être déplacées immédiatement de façon forcée.

40. Dispositif selon l'une ou plusieurs des revendications précédentes, **caractérisé en ce que** la griffe (3) est munie d'un élément de traction, par l'intermédiaire duquel elle peut être déplacée, chaque fois que la pression de réglage est égale à la pression atmosphérique (Pₐ).

41. Dispositif selon l'une ou plusieurs des revendications précédentes, **caractérisé en ce que** les griffes (3) sont conçues de telle sorte qu'elles sont situées sur le côté sur lequel est générée une pression qui est supérieure à la pression sous vide (Pᵥ).
